# EUROPÄISCHE PATENTSCHRIFT

(11) **EP 2 193 543 B1**
(45) Veröffentlichungstag und Bekanntmachung des Hinweises auf die Patenterteilung: **24.07.2019**
(21) Anmeldenummer: 08785627.4
(22) Anmeldetag: 19.08.2008
(51) Int. Cl.: H01L 23/373, H01L 23/427, H05K 7/20

(54) **VERFAHREN ZUM BETREIBEN EINES ELEKTRISCHEN GERÄTS**
METHOD FOR OPERATING AN ELECTRICAL DEVICE
PROCÉDÉ POUR FAIRE FONCTIONNER UN DISPOSITIF ÉLECTRIQUE

(30) Priorität: 25.08.2007 DE 102007040430
(43) Veröffentlichungstag der Anmeldung: 09.06.2010
(73) Patentinhaber: SEW-EURODRIVE GmbH & Co. KG, 76646 Bruchsal (DE)
(72) Erfinder: MARAHRENS, Klaus, 76337 Waldbronn-Reichenbach (DE)
(86) Internationale Anmeldenummer: PCT/EP2008/006814
(87) Internationale Veröffentlichungsnummer: WO 2009/027038

(56) Entgegenhaltungen:
- DE-A1- 19 932 441
- US-A1- 2004 240 181
- US-A1- 2005 073 816
- US-A1- 2007 057 365
- US-A1- 2007 187 460
- US-B1- 6 377 474

## Beschreibung

Die Erfindung betrifft ein Verfahren zum Betreiben eines elektrischen Geräts.

Leistungshalbleiter werden zur Entwärmung meist an Kühlkörper angeschraubt, wobei Wärmeleitpaste vorgesehen wird.

Aus der US 2004/240181 A1 ist als nächstliegender Stand der Technik eine Wärmesdissipationsanordnung bekannt.

Aus der US 2007/057365 A1 ist eine Anordnung zur Verhinderung einer oxidativ bedingten Schmelzpunkterniedrigung bei einem Wärmetransfermedium bekannt. Aus der US 2007/187460 A1 ist eine Halbleiteranordnung mit einem thermischen Wärmeleitmaterial bekannt.

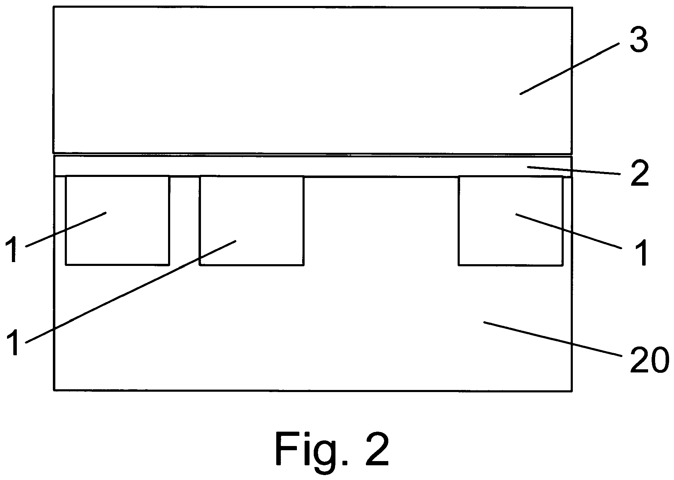

Aus der US 6 377 474 B1 ist ein Prozessorsockel mit Wärmeleitanordnung bekannt. Aus der Figur 2 der US 2005/0073816 A1 sind O-Ringe bekannt, welche zum Abdichten eines gegebenenfalls schmelzenden, zwischen Kühlkörper und mikroelektrischem Paket angeordneten Materials vorgesehen sind, wobei das noch feste Material zwischen Vorsprüngen des Kühlkörpers angeordnet ist.

Der Erfindung liegt daher die Aufgabe zugrunde, die Standzeit von Leistungsbauelementen zu verbessern.

Erfindungsgemäß wird die Aufgabe bei dem Verfahren nach den in Anspruch 1 angegebenen Merkmalen gelöst.

Wichtige Merkmale bei dem Verfahren zum Betreiben eines elektrischen Geräts sind, dass es zumindest ein Leistungsbauelement und einen Kühlkörper umfasst, an den zumindest teilweise die von dem Leistungsbauelement erzeugte Wärme abgeführt wird,
wobei zwischen Kühlkörper und Leistungsbauelement eine Metallfolie angeordnet ist, deren Schmelzpunkt unterhalb der maximal zulässigen Betriebstemperatur des Leistungsbauelements liegt, insbesondere also unterhalb der bei maximal zulässiger Auslastung des Leistungsbauelements auftretenden Temperatur,
wobei Leistungshalbleiter des Leistungsbauelements derart mit unterschiedlicher Leistung betrieben werden, dass eine räumlich und zeitlich veränderliche Temperaturverteilung an der der Metallfolie zugewandten Seite des Leistungsbauelements entsteht.

Von Vorteil ist dabei, dass die Unterschiedlichkeit der Verteilung sehr stark sein darf. Insbesondere sogar so stark, dass eine Teilzerstörung des Wärmeübergangs auftritt.

Insbesondere bei einer vorteilhaften Ausgestaltung die Temperaturverteilung derart erzeugt, dass
- zu einem ersten Zeitpunkt ein erster Leistungshalbleiter eine höhere Temperatur aufweist als ein zweiter,
- zu einem zweiten Zeitpunkt der zweite Leistungshalbleiter eine höhere Temperatur aufweist als der erste,
- infolge entstandener mechanischer Spannungen eine derartige Verschlechterung des Wärmeübergangs zur Metallfolie erzeugt wird, dass die Temperatur eines der Leistungshalbleiter über die Schmelzpunkttemperatur ansteigt und danach wieder diese unterschreitet.

Vorteiligerweise ist also ein Selbstheilung vorgesehen, die zu einer Verbesserung des Wärmeübergangs führt und somit zu einem nachfolgenden Abfallen der Temperatur.

Insbesondere ist die Temperaturverteilung derart erzeugt, dass
- zu einem ersten Zeitpunkt ein erster Bereich der der Metallfolie zugewandten Oberfläche des Leistungsbauelements eine höhere Temperatur aufweist als ein zweiter,
- zu einem zweiten Zeitpunkt der zweite Bereich eine höhere Temperatur aufweist als der erste,
- infolge entstandener mechanischer Spannungen eine derartige Verschlechterung des Wärmeübergangs zur Metallfolie erzeugt wird, dass die Temperatur eines der Bereiche über die Schmelzpunkttemperatur ansteigt und danach wieder diese unterschreitet.

Von Vorteil ist wiederum, dass also ein Selbstheilung vorgesehen ist, die zu einer Verbesserung des Wärmeübergangs führt und somit zu einem nachfolgenden Abfallen der Temperatur.

Alternativ sind wichtige Merkmale, dass Leistungshalbleiter des Leistungsbauelements mit einer zeitweise derart hohen Leistung betrieben werden, dass die Metallfolie zumindest in einem ihnen benachbarten Teilbereich ihren Schmelzpunkt überschreitet, insbesondere zur Verbesserung des Wärmeübergangs. Von Vorteil ist dabei, dass ohne äußeres Ansteuern oder Einwirken Defekt des Wärmeübergangs von selbst ausgeglichen werden.

Wichtige Merkmale der Erfindung sind, dass es zumindest ein Leistungsbauelement und einen Kühlkörper zur zumindest teilweisen Abfuhr der von dem Leistungsbauelement erzeugten Wärme umfass, wobei zwischen Kühlkörper und Leistungsbauelement eine Metallfolie angeordnet ist, deren Schmelzpunkt unterhalb der maximal zulässigen Betriebstemperatur des Leistungsbauelements liegt, insbesondere also unterhalb der bei maximal zulässiger Auslastung des Leistungsbauelements auftretenden Temperatur.

Von Vorteil ist dabei, dass eine stoffschlüssige Verbindung herstellbar ist zum Kühlkörper und Leistungsbauelement, indem zu Beginn des Betriebs kontrolliert eine hohe Temperatur der Leistungshalbleiter erzeugt wird, die über dem Schmelzpunkt der Metallfolie liegt. Somit ist dann ein Phasenübergang des Materials zumindest in einem Teilbereich der Metallfolie ausgeführt. Das flüssig oder zumindest sehr leicht plastisch verformbare Material der Metallfolie fließt dann entsprechend der wirkenden Kräfte. Somit wird ein Stoffschluss zwischen Metallfolie und Kühlkörper sowie zwischen Metallfolie und Leistungsbauelement herstellbar. Dieser Stoffschluss bleibt bei nachfolgendem Abkühlen erhalten und bewirkt einen sehr geringen Wärmeübergangswiderstand von der Metallfolie in die jeweils angrenzenden Teile im Bereich des Stoffschlusses. Wärmeleitpaste ist nicht nötig. Ausschwemmungen treten nicht auf.

Als Material für die Metallfolie ist eine Metalllegierung verwendet, die hier stets als Metall bezeichnet wird.
Bei einer vorteilhaften Ausgestaltung ist das Leistungsbauelement ein Leistungshalbleiter. Von Vorteil ist dabei, dass ein einziger Halbleiter verwendbar ist, obwohl er eine ungefähr zentralsymmetrische Temperaturverteilung in der der Metallfolie zugewandten Oberfläche des Leistungsbauelements aufweist. Dies bedeutet auch, dass in Randbereichen die Temperatur niedriger ist als im zentralen mittigen Bereich der Kontaktfläche zur Metallfolie hin.

Bei einer vorteilhaften Ausgestaltung ist das Leistungsbauelement ein Modul, in dem zumindest verschieden ausgelastete Leistungshalbleiter integriert sind. Von Vorteil ist dabei, dass die Erfindung auch anwendbar ist bei großen Leistungsbauelementen, die verschiedene oder gleichartig aber verschieden betriebene Leistungshalbleiter umfassen. Insbesondere sind diese in einer Ebene oder Fläche angeordnet.
Bei einer vorteilhaften Ausgestaltung weist die der Metallfolie zugewandte Oberfläche eine räumlich und zeitlich veränderliche Temperaturverteilung auf. Von Vorteil ist dabei, dass die Erfindung trotzdem einen guten Wärmeübergang gewährleistet. Selbst wenn die Temperaturunterschiede und -Verläufe derart drastisch sind, dass hohe mechanische Spannungen in der Metallfolie entstehen, die den Wärmeübergang verschlechtern. Denn dann tritt die Selbstheilung in Kraft mittels der Verflüssigung des Materials.
Bei einer vorteilhaften Ausgestaltung ist die Metallfolie stoffschlüssig zum Kühlkörper und/oder zum Leistungsbauelement hin verbunden. Von Vorteil ist dabei, dass der Wärmeübergang sehr gut ist, also der Wärmeübergangswiderstand durch den Stoffschluss hinweg von dem Leistungsbauelement zur Metallfolie beziehungsweise von der Metallfolie zum Kühlkörper.

Bei einer vorteilhaften Ausgestaltung sind die Leistungshalbleiter in einer Ebene oder Fläche des Leistungsmoduls angeordnet. Von Vorteil ist dabei, dass innerhalb der Ebene eine verschiedene Temperaturverteilung bewirkt werden darf. Dabei ist es so erlaubt, dass die Temperatur an einer ersten Stelle die Schmelzpunkttemperatur der Metallfolie überschreitet und an einer anderen Stelle unterschreitet.
Bei einer vorteilhaften Ausgestaltung sind die Leistungshalbleiter des Moduls mit verschiedener Auslastung betreibbar. Von Vorteil ist dabei, dass die entstehenden Spannungen innerhalb der Ebene oder Fläche und innerhalb der Kontaktfläche zur Metallfolie kompensierbar sind, insbesondere unter Verwendung des Phasenübergangs.
Bei einer vorteilhaften Ausgestaltung weisen Leistungshalbleiter des Moduls unterschiedlich große maximale Verlustleistung auf. Von Vorteil ist dabei, dass unterschiedlich hohe Temperaturen erzeugbar sind und wie schon gesagt, die Spannungen abbaubar sind.

Bei einer vorteilhaften Ausgestaltung sind Bereiche mit verschlechtertem Wärmeübergang, insbesondere infolge abhängig von der Betriebsweise thermisch bedingter mechanischer Spannungen, selbstheilend, insbesondere liegt nach Überschreiten einer kritischen Temperatur in diesen Bereichen, die über oder wenig unter dem Schmelzpunkt. Insbesondere werden die Metallfolie aus einem derartigen Material mit einem derartigen Schmelzpunkt hergestellt und die Leistungshalbleiter mit einer derartigen Leistung betrieben, dass bei einer Verschlechterung des Wärmeübergangs vom Leistungsbauelement und/oder vom Kühlkörper zur Metallfolie eine derartige Temperaturerhöhung auftritt, dass die Metallfolie derart plastisch verformt oder flüssig wird, dass die Verschlechterung beseitigt ist. Von Vorteil ist dabei, dass eine Selbstheilung vorgesehen ist. Somit ist sogar bei einer Zerstörung von Teilbereichen des Wärmeübergangs mittels der dann auftretenden normalerweise gefährlichen Erhöhung eine Reparatur der zerstörten Gebiete automatisch vorgesehen.
Bei einer vorteilhaften Ausgestaltung werden die Leistungshalbleiter mit einer zeitweise derart hohen Leistung betrieben, dass die Metallfolie zumindest in einem Teilbereich ihren Schmelzpunkt überschreitet. Von Vorteil ist dabei, dass eine Betriebsweise mit hohen Verlustleistung erlaubt ist und die unterschiedlichen Halbleiter unterschiedlich stark auslastbar sind.

Wichtige Merkmale bei der Verwendung ist, dass eine Metallfolie zur Wärmeabfuhr und/oder -Durchleitung von einem Leistungsmodul an einen Kühlkörper verwendet ist,
wobei das Leistungsmodul Leistungshalbleiter umfasst, insbesondere in einer Ebene oder Fläche angeordnete.
Von Vorteil ist dabei, dass bei dem Leistungsmodul zwar mehrere verschiedene Leistungshalbleiter vorsehbar sind, die somit auch je nach Betriebsart und Positionierung im Leistungsbauelement verschiedene Wärmeleistungen erzeugen und infolge dessen auch entsprechend stark variierende Temperaturen innerhalb der Ebene oder Fläche, wobei daraus mechanische Spannungen erzeugbar sind, die zu einer Verschlechterung des Wärmeübergangs führen können. Trotzdem ist mittels der Folie ein Verzicht auf Wärmeleitpaste erreichbar. Denn die Folie ist sozusagen selbstheilend.

Wesentlicher Unterschied des Leistungsbauelements zu einem hochintegrierten Chip der Signalelektronik ist dass bei solchen Chips viele Millionen Schalter in einer Ebene angeordnet sind, die im Wesentlichen gleichmäßig belastet sind. Die Temperaturverteilung innerhalb der Ebene ist also im Wesentlichen konstant. Dies gilt sogar für jede Betriebsweise. Im Gegensatz hierzu sind die Leistungshalbleiter mit einem Abstand von einigen Millimetern zueinander im Leistungsmodul angeordnet, so dass es Bereiche gibt, in denen erhebliche Wärme erzeugt wird und mehrere Millimeter große Bereiche, in welchen keine Wärme erzeugt sondern höchstens aufgespreizt wird. Somit ist die räumliche Temperaturverteilung viel stärker variierend als bei den Chips. Bei den Chips sind die Abstände zwischen den Schaltern im µm Bereich und kleiner. Dies führt zu einer im Wesentlichen gleichförmigen Auslastung.
Weitere Vorteile ergeben sich aus den Unteransprüchen.

Die Erfindung wird nun anhand von Abbildungen näher erläutert:

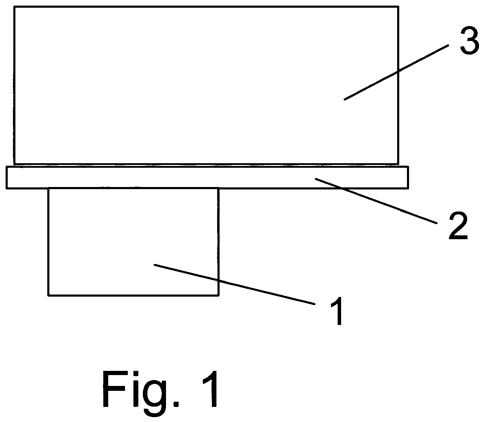

In der Figur 1 ist eine erfindungsgemäße Vorrichtung in Schnittansicht gezeichnet. Hierbei ist der Leistungshalbleiter 1 über eine Metallfolie 2 anstatt einer Wärmeleitpaste zum Kühlkörper 3 hin entwärmt.
Die Metallfolie besteht aus einem metallischen Material, dessen Schmelzpunkt sehr niedrig liegt, insbesondere im zulässigen Betriebsbereich der Leistungshalbleiter.
Der Leistungshalbleiter darf dauerhaft betrieben werden bis zu einer ersten kritischen Temperatur. Bei der Erfindung ist der Schmelzpunkt der Metallfolie 2 derart gewählt, dass er gleich ist oder nur geringfügig unter der ersten kritische Temperatur liegt.
Dadurch, dass der Schmelzpunkt im Bereich des oberen Endes der Bereiches der Arbeitstemperaturen liegt, ist es ermöglicht durch entsprechende von der Steuerelektronik vorgebbare elektrische Belastung der Leistungshalbleiter 1 den Schmelzpunkt zu erreichen.
Bei Erreichen des Schmelzpunktes fließt das metallische Material in die mikroskopischen Unebenheiten der Oberfläche.

In einem nachfolgenden Schritt wird die Belastung wiederum abgesenkt, so dass das metallische Material wiederum in den festen Aggregatzustand wechselt. Dabei verbleibt aber eine gewisse Elastizität, die ausreicht, um mechanische Spannungen aufzunehmen, die im Betrieb entstehen. Diese mechanischen Spannungen werden beispielsweise durch Temperaturhübe, also Temperaturveränderungen der Leistungshalbleiter erzeugt. Dabei verbleibt das metallische Material im elastischen Zustand.
Vorzugsweise ist der Leistungshalbleiter ein elektronischer Schalter, wie IGBT oder MOSFET, der auf seiner der Metallfolie 2 zugewandten Seite ein metallisches Gehäuseteil aufweist. Somit ist nach dem Schmelzen der Metallfolie 2 ein geringer thermischer Übergangswiderstand erreichbar, insbesondere ist der Übergang stoffschlüssig oder im Wesentlichen einer stoffschlüssigen Verbindung ähnlich.

Wie bei einer Schweißverbindung ist der Übergangsbereich von der metallischen Gehäuseseite zur Metallfolie im Wesentlichen unmittelbar. Lufteinschlüsse sind im Wesentlichen vermieden und die Wärme fließt direkt vom Metall des metallischen Gehäuseteils des Leistungshalbleiters zur Metallfolie.

Ebenso ist der Übergang vom Kühlkörper zur Metallfolie vorgesehen. Auch dieser Übergang ist stoffschlüssig oder im Wesentlichen einer stoffschlüssigen Verbindung ähnlich. Wie bei einer Schweißverbindung ist auch hier der Übergangsbereich vom Kühlkörper zur Metallfolie im Wesentlichen unmittelbar. Lufteinschlüsse sind im Wesentlichen vermieden und die Wärme fließt direkt vom Metall des Kühlkörpers, insbesondere vorzugsweise aus Aluminium, zur Metallfolie.
Bei einem weiteren erfindungsgemäßen Ausführungsbeispiel wird zusätzlich eine von einem Federelement erzeugte Anpresskraft des Leistungshalbleiters 1 in Richtung auf den Kühlkörper hin ausgeübt. Somit wird bei Erreichen des Schmelzpunktes das verflüssigte metallische Material regelrecht hineingepresst in Unebenheiten der Oberfläche.
Auf diese Weise ist Wärmeleitpaste verzichtbar.
Bei einem weiteren erfindungsgemäßen Ausführungsbeispiel wird statt des Leistungshalbleiters ein Leistungsmodul verwendet, das elektronische Leistungsschalter, wie beispielsweise IGBT, MOSFET oder Thyristoren, und auch andere Leistungs-Bauelemente, wie Dioden, oder dergleichen umfasst. Es sind auch Bauelemente mit vorsehbar in dem Leistungsmodul, die keine Leistungsbauelemente sind, also nur geringe Verlustleistungen erzeugen.
Je nach Betriebsweise des Geräts sind auch gewisse Leistungs-Bauelemente des Moduls weniger stark ausgelastet als zulässig.
Das Modul ist ebenfalls über die Metallfolie zum Kühlkörper hin entwärmt.
Dabei ist also die Wärmeverteilung in der Kontaktebene oder Kontaktfläche des Moduls zur Metallfolie hin unterschiedlich, insbesondere räumlich und zeitlich.

Das heißt, dass zu verschiedenen Zeitpunkten die Form der räumlichen Temperaturverteilung unterschiedlich ist. Außerdem ist die Temperaturverteilung abhängig von der Betriebsweise des Geräts.
Beispielsweise bilden sechs Leistungsschalter die Endstufe eines Umrichters, also einen Wechselrichter. Außerdem sind auf dem Leistungsmodul auch sechs Dioden eines dreiphasig betreibbaren Gleichrichters angeordnet und ein weiterer Leistungsschalter zum Steuern des Energieflusses der insbesondere bei generatorischem Betrieb erzeugten Energie an einen Bremswiderstand. Wenn nun im motorischen Betrieb dieser weitere Leistungsschalter unbelastet ist, wird von ihm keine Verlustwärme erzeugt. Die Leistungsschalter der Endstufe erzeugen jedoch erhebliche Wärme. Bei Übergang in den generatorischen Betrieb erzeugt der weitere Leistungsschalter ebenfalls erhebliche Wärme.
Auf dem Modul sind die Leistungsbauelemente, insbesondere also Leistungsschalter und Dioden, in einer Ebene oder Fläche angeordnet. Somit ist die Temperaturverteilung in dieser Ebene oder Fläche abhängig von der Betriebsweise des Geräts, also auch der Leistungsschalter.
Wegen der zeitlich und räumlich wechselnden Temperaturverteilung werden an der der Folie zugewandten Seite des Leistungsmoduls entsprechend wechselnde mechanische Spannungen erzeugt.
Vorteiligerweise ist die Folie stoffschlüssig verbunden und nimmt die Dehnungen und Stauchungen auf. Im Gegensatz zu einer Wärmeleitpaste treten keine Ausschwemm-Effekte auf. Die Metallfolie ist beidseitig stoffschlüssig verbunden, also mit Leistungsmodul und Kühlkörper. Die Metallfolie weist eine entsprechend hohe Elastizität auf. Weiterer Vorteil ist der niedrige Schmelzpunkt der Metallfolie. Denn in demjenigen Bereich, in welchem hohe Temperaturen auftreten sind diese Temperaturen nahe dem Schmelzpunkt oder sogar in Mikrobereichen um den Schmelzpunkt herum. Die bei diesen hohen Temperaturen auftretenden hohen Spannungen werden also durch die angepasste Elastizitätserhöhung besonders gut ausgeglichen. Bei Überschreiten des Schmelzpunktes wird die Folie sogar flüssig und die Spannungen werden vollumfänglich unwirksam, da das Material in diesem Bereich dann fließt und sich an die verschobene Oberflächenbereiche des Leistungsmoduls anpasst.

Falls nun bei Abkühlung mechanische Spannungen derart auftreten, dass eine Verschlechterung der stoffschlüssigen Verbindung und somit auch des thermischen Übergangs auftritt, führt dies zu keinem Ausfall des Geräts, da bei niedrigeren Temperaturen an die Wärmeabfuhr keine so hohen Anforderungen gestellt sind. Wenn sich jedoch durch die verschlechterte Wärmabfuhr die Temperatur erhöhen sollte, ist spätestens beim Schmelzpunkt ein Abbau der Spannungen sicher gestellt.
Die Erfindung ermöglicht also, dass thermisch bedingte, an der der Metallfolie zugewandten Seite des Leistungsmoduls auftretende mechanische Spannungen auch bei Veränderung nicht zu einer gefährlichen Verschlechterung des Wärmeübergangs führen. Denn selbst bei einer Verschlechterung und damit verbundenen Erhöhung der Temperatur ist ab Überschreiten einer kritischen Temperatur eine Verflüssigung und somit eine Verbesserung des Wärmeübergangs in diesem Bereich ermöglicht.

In Figur 2 ist hierzu ein Beispiel für ein solches Leistungsmodul 20 gezeigt, bei dem zwischen zwei der Leistungshalbleiter 1 sogar ein größerer Abstand vorgesehen ist als die Größe eines der Leistungshalbleiter beträgt. Hierbei sind die Leistungshalbleiter 1 im Wesentlichen gleich groß ausgeführt. Die Leistungshalbleiter sind also in einer Ebene angeordnet, aber in unregelmäßigen Abständen. Im Bereich des größeren Abstandes tritt abhängig von der Betriebsweise der Leistungshalbleiter 1 die erwähnte mechanische Spannung auf, die sogar zur Verschlechterung des Wärmeübergangs führen kann. Als Folge hiervon tritt dann die beschriebene Selbstheilung in Abhängigkeit von der Betriebsweise auf, insbesondere bei weiter hoher Auslastung der Leistungshalbleiter 1.

### Bezugszeichenliste

1 Leistungshalbleiter
2 Metallfolie
3 Kühlkörper
20 Leistungsmodul

## Patentansprüche

1. Verfahren zum Betreiben eines elektrischen Geräts
wobei das elektrische Gerät zumindest ein Leistungsbauelement und einen Kühlkörper (3) umfasst, an den zumindest teilweise die von dem Leistungsbauelement erzeugte Wärme abgeführt wird,
wobei zwischen Kühlkörper (3) und Leistungsbauelement eine Metallfolie (2) angeordnet ist, deren Schmelzpunkt unterhalb der maximal zulässigen Betriebstemperatur des Leistungsbauelements liegt, insbesondere also unterhalb der bei maximal zulässiger Auslastung des Leistungsbauelements auftretenden Temperatur,
wobei Leistungshalbleiter (1) des Leistungsbauelements derart mit unterschiedlicher Leistung betrieben werden, dass eine räumlich und zeitlich veränderliche Temperaturverteilung an der der Metallfolie (2) zugewandten Seite des Leistungsbauelements entsteht,
wobei die Metallfolie (2) stoffschlüssig zum Kühlkörper (3) und zum Leistungsbauelement hin verbunden ist,
wobei das Leistungsbauelement mit einer zeitweise derart hohen Leistung betrieben wird, dass die Metallfolie (2) zumindest in einem Teilbereich ihren Schmelzpunkt überschreitet,
**dadurch gekennzeichnet, dass**
das Leistungsbauelement über die Metallfolie (2) gegen den Kühlkörper (3) von einem Federelement gedrückt angeordnet ist,
wobei eine Kontaktfläche des Leistungsbauelements mit dem Kühlkörper (3) über die Metallfolie (2) hinweg elektrisch verbunden ist zur Schaffung einer elektrischen Masseverbindung,
wobei die vom Federelement erzeugte Anpresskraft des Leistungsbauelements in Richtung auf den Kühlkörper hin so ausgeübt wird, dass bei Erreichen des Schmelzpunktes das verflüssigte metallische Material in Unebenheiten der Oberfläche des Leistungsbauelements hineingepresst wird,
wobei das Leistungsbauelement ein Modul ist, in dem zumindest verschieden ausgelastete Leistungshableiter integriert sind,
wobei der Abstand zwischen zwei der Leistungshalbleiter (1) größer ist als die Größe eines der Leistungshalbleiter (1),
wobei die Leistungshalbleiter (1) zueinander gleich groß ausgeführt sind,
wobei die Temperaturverteilung derart erzeugt ist, dass
- zu einem ersten Zeitpunkt ein erster Leistungshalbleiter (1) eine höhere Temperatur aufweist als ein zweiter,
- zu einem zweiten Zeitpunkt der zweite Leistungshalbleiter (1) eine höhere Temperatur aufweist als der erste,
- infolge entstandener mechanischer Spannungen eine derartige Verschlechterung des Wärmeübergangs zur Metallfolie (2) erzeugt wird, dass die Temperatur eines der Leistungshalbleiter (1) über die Schmelzpunkttemperatur der Metallfolie (2) ansteigt und danach wieder diese unterschreitet.

2. Verfahren nach Anspruch 1,
**dadurch gekennzeichnet, dass**
die der Metallfolie (2) zugewandte Oberfläche des Leistungsbauelements eine räumlich und zeitlich veränderliche Temperaturverteilung aufweist.

3. Verfahren nach einem der vorangegangenen Ansprüche,
**dadurch gekennzeichnet, dass**
die Leistungshalbleiter (1) in einer Ebene oder Fläche des Leistungsmoduls (20) angeordnet sind

4. Verfahren nach einem der vorangegangenen Ansprüche,
**dadurch gekennzeichnet, dass**
die Leistungshalbleiter (1) des Moduls mit verschiedener Auslastung betrieben werden.

5. Verfahren nach einem der vorangegangenen Ansprüche,
**dadurch gekennzeichnet, dass**
Leistungshalbleiter (1) des Moduls unterschiedlich große maximale Verlustleistung aufweisen.

6. Verfahren nach einem der vorangegangenen Ansprüche,
**dadurch gekennzeichnet, dass**
Bereiche der Metallfolie (2) mit verschlechtertem Wärmeübergang infolge abhängig von der Betriebsweise thermisch bedingter mechanischer Spannungen selbstheilend nach Überschreiten einer kritischen Temperatur in diesen Bereichen, die über oder wenig unter dem Schmelzpunkt liegt.

7. Verfahren nach einem der vorangegangenen Ansprüche,
**dadurch gekennzeichnet, dass**
die Temperaturverteilung derart erzeugt ist, dass
- zu einem ersten Zeitpunkt ein erster Bereich der der Metallfolie (2) zugewandten Oberfläche des Leistungsbauelements eine höhere Temperatur aufweist als ein zweiter,
- zu einem zweiten Zeitpunkt der zweite Bereich eine höhere Temperatur aufweist als der erste,
- infolge entstandener mechanischer Spannungen eine derartige Verschlechterung des Wärmeübergangs zur Metallfolie (2) erzeugt wird, dass die Temperatur eines der Bereiche über die Schmelzpunkttemperatur ansteigt und danach wieder diese unterschreitet.

## Claims

1. Method for operating an electrical device,
wherein the electrical device comprises at least one power component and a cooling member (3), to which at least some of the heat generated by the power component is carried away,
wherein a metal foil (2) is arranged between the cooling member (3) and the power component, the melting point of said foil being below the maximum permitted operating temperature of the power component, thus in particular below the temperature that occurs when the power component is at its maximum permitted utilisation,
wherein power semiconductors (1) of the power component are operated at different powers such as to produce a spatially and temporally variable temperature distribution on the power component side facing the metal foil (2),
wherein the metal foil (2) is integrally bonded to the cooling member (3) and to the power component,
wherein the power component is operated at a power that is intermittently so high that the metal foil (2) exceeds its melting point at least in one portion,
**characterised in that**
the power component is arranged so as to be pushed against the cooling member (3) by a resilient element by way of the metal foil (2),
wherein a contact face of the power component is electrically connected to the cooling member (3) over the metal foil (2) so as to establish an electrical earth connection,
wherein the contact force generated by the resilient element on the power component in the direction of the cooling member is exerted such that, when the melting point is reached, the liquefied metal material is pressed into uneven regions of the surface of the power component,
wherein the power component is a module in which at least power semiconductors utilised to different levels are integrated,
wherein the distance between two of the power semiconductors (1) is greater than the size of one of the power semiconductors (1),
wherein the power semiconductors (1) are configured to be the same size as one another, wherein the temperature distribution is generated such that
- at a first time, a first power semiconductor (1) is at a higher temperature than a second power semiconductor,
- at a second time, the second power semiconductor (1) is at a higher temperature than the first power semiconductor,
- due to the resulting mechanical stresses, the heat transfer to the metal foil (2) is impaired to such an extent that the temperature of one of the power semiconductors (1) increases beyond the melting point temperature of the metal foil (2) and then drops back below said temperature.

2. Method according to claim 1,
**characterised in that**
the power component surface facing the metal foil (2) has a spatially and temporally variable temperature distribution.

3. Method according to any of the preceding claims,
**characterised in that**
the power semiconductors (1) are arranged in a plane or face of the power module (20).

4. Method according to any of the preceding claims,
**characterised in that**
the power semiconductors (1) of the module are operated at different utilisation levels.

5. Method according to any of the preceding claims,
**characterised in that**
power semiconductors (1) of the module have different maximum power losses.

6. Method according to any of the preceding claims,
**characterised in that**
regions of the metal foil (2) that have impaired heat transfer due to heat-related mechanical stresses depending on the mode of operation are self-healing after a critical temperature, which is higher than or slightly below the melting point, is exceeded in said regions.

7. Method according to any of the preceding claims,
**characterised in that**
the temperature distribution is generated such that
- at a first time, a first region of the power component surface facing the metal foil (2) is at a higher temperature than a second region,
- at a second time, the second region is at a higher temperature than the first region,
- due to resulting mechanical stresses, the heat transfer to the metal foil (2) is impaired to such an extent that the temperature of one of the regions increases beyond the melting point temperature and then drops back below said temperature.

## Revendications

1. Procédé dévolu à l'actionnement d'un appareil électrique,
ledit appareil électrique incluant au moins un composant de puissance et un corps de refroidissement (3) sur lequel la chaleur, engendrée par ledit composant de puissance, est dissipée au moins en partie,
avec interposition, entre ledit corps de refroidissement (3) et ledit composant de puissance, d'une feuille métallique (2) dont le point de fusion se situe en deçà de la température maximale admissible de fonctionnement dudit composant de puissance, c'est-à-dire, en particulier, en deçà de la température survenant en présence d'une charge maximale admissible dudit composant de puissance,
sachant que des semi-conducteurs de puissance (1) dudit composant de puissance sont exploités avec des puissances différentes, de manière à créer une répartition de température variable dans l'espace et dans le temps, sur la face dudit composant de puissance qui est tournée vers ladite feuille métallique (2),
laquelle feuille métallique (2) est reliée matériellement audit corps de refroidissement (3) et audit composant de puissance,
sachant que ledit composant de puissance est exploité avec une puissance présentant, par intermittence, une valeur élevée telle que la feuille métallique (2) excède son point de fusion, au moins dans une région partielle,
**caractérisé par le fait que**
le composant de puissance est pressé contre le corps de refroidissement (3) par un élément élastique, par l'intermédiaire de la feuille métallique (2),
sachant qu'une surface de contact dudit composant de puissance, avec ledit corps de refroidissement (3), est raccordée électriquement par l'entremise de ladite feuille métallique (2), en vue d'instaurer une connexion électrique à la masse,
sachant que la force développée par l'élément élastique, pressant le composant de puissance en direction du corps de refroidissement, est appliquée de façon telle que, lorsque le point de fusion est atteint, le matériau métallique liquéfié soit introduit, sous pression, dans des défauts de planéité de la surface dudit composant de puissance,
lequel composant de puissance est un module dans lequel sont intégrés des semi-conducteurs de puissance au moins soumis à des charges différentes,
la distance séparant deux, parmi lesdits semi-conducteurs de puissance (1), étant supérieure au dimensionnement de l'un desdits semi-conducteurs de puissance (1), lesquels semi-conducteurs de puissance (1) sont réalisés avec dimensionnements mutuellement identiques,
sachant que la répartition de température est créée de telle sorte
- qu'à un premier instant, un premier semi-conducteur de puissance (1) présente une température plus élevée que celle d'un second semi-conducteur,
- qu'à un second instant, ledit second semi-conducteur de puissance (1) présente une température plus élevée que celle dudit premier semi-conducteur,
- que, sous l'effet de tensions mécaniques survenues, une dégradation du transfert de chaleur vers la feuille métallique (2) soit engendrée de façon telle que la température de l'un desdits semi-conducteurs de puissance (1) croisse au-delà de la température du point de fusion de ladite feuille métallique (2), et dépasse ensuite de nouveau négativement cette température.

2. Procédé selon la revendication 1,
**caractérisé par le fait que**
la surface du composant de puissance, tournée vers la feuille métallique (2), présente une répartition de température variable dans l'espace et dans le temps.

3. Procédé selon l'une des revendications précédentes,
**caractérisé par le fait que**
les semi-conducteurs de puissance (1) sont disposés dans un plan ou une surface du module de puissance (20).

4. Procédé selon l'une des revendications précédentes,
**caractérisé par le fait que**
les semi-conducteurs de puissance (1) du module sont exploités avec des charges différentes.

5. Procédé selon l'une des revendications précédentes,
**caractérisé par le fait que**
des semi-conducteurs de puissance (1) du module présentent des puissances dissipées maximales de valeurs différentes.

6. Procédé selon l'une des revendications précédentes,
**caractérisé par le fait que**
des régions de la feuille métallique (2), dont le transfert de chaleur est dégradé, se régénèrent d'elles-mêmes sous l'effet de tensions mécaniques thermiquement tributaires du mode de fonctionnement, après dépassement, dans ces régions, d'une température critique située au-delà ou légèrement en deçà du point de fusion.

7. Procédé selon l'une des revendications précédentes,
**caractérisé par le fait que**
la répartition de température est créée de telle sorte
- qu'à un premier instant, une première région de la surface du composant de puissance, tournée vers la feuille métallique (2), présente une température plus élevée que celle d'une seconde région,
- qu'à un second instant, ladite seconde région présente une température plus élevée que celle de ladite première région,
- que, sous l'effet de tensions mécaniques survenues, une dégradation du transfert de chaleur vers la feuille métallique (2) soit engendrée de façon telle que la température de l'une desdites régions croisse au-delà de la température du point de fusion, et dépasse ensuite de nouveau négativement cette température.
